(19) Europäisches Patentamt
European Patent Office
Office européen des brevets

(11) Publication number: 0 178 038
B1

(12) EUROPEAN PATENT SPECIFICATION

(45) Date of publication of patent specification: 30.11.88

(51) Int. Cl.$^4$: H 05 K 9/00, H 05 F 3/02

(21) Application number: 85304003.8

(22) Date of filing: 05.06.85

# (54) Electrically conductive anti-static work station.

(30) Priority: 10.10.84 US 659292

(43) Date of publication of application:
16.04.86 Bulletin 86/16

(45) Publication of the grant of the patent:
30.11.88 Bulletin 88/48

(84) Designated Contracting States:
BE DE FR GB IT NL

(56) References cited:
US-A-3 801 418
US-A-4 494 651

(73) Proprietor: W.R. GRACE & CO.
Grace Plaza 1114 Avenue of the Americas
New York New York 10036 (US)

(72) Inventor: Wilkie, Robert Russell
303 Riverside Trail
Roanoke Rapids North Carolina 27870 (US)

(74) Representative: Barlow, Roy James et al
J.A.KEMP & CO. 14, South Square Gray's Inn
London WC1R 5EU (GB)

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

EP 0 178 038 B1

**Description**

The present invention relates to a portable container for transporting an electrically sensitive device, for example a micro circuit device which may undergo spontaneous electrostatic breakdown in an electrostatic field or an electromagnetic field.

In order to prevent electrostatic breakdowns, containers for such devices have been provided with means for short-circuiting the terminals or pins of the devices during storage.

With such devices, an indentification system is clearly necessary for field repair situations since the repair technician cannot physically carry a vast array of cases with him for on-site repair. He has to carry several different devices within a single container and, in many cases, has to carry several containers each containing differing electrically sensitive devices. Thus a window is necessary to solve the identification problem, since the case which shielded the electrically sensitive device from the possible harmful effects of external electrical forces would otherwise have to be opened by the field technician in order to ascertain the location of a given electrically sensitive device. In many instances this would render the contained devices electrically defective. Moreover, even an electrically conductive window constitutes a discontinuity of the case.

It is an object of the present invention to provide a container which effectively shields electrically sensitive devices from the adverse effects of external electrical forces and static charges wherein the container is provided with a window which does not give rise to discontinuity in the shielding effect.

It has been found that lateral movement of the window relative to the container can create the possibility of a crack or space between one edge of the window material and the container at the junction of the window material and the relative portion of the container. Such a discontinuity in the outer conductive surface of the container could result in a loss of the conductivity of the outer case and could also allow the introduction of dust into the interior of the container.

US—A—3801418 discloses a window assembly for an anti-static device in which the outer surface of an electrically-resistive transparent window panel has an electrically conductive coating applied thereto and is electrically connected to the surrounding frame by intimate contact, either directly or through the agency of an electrically conductive gasket.

Accordingly the present invention provides a portable work station adapted to transport a device which is sensitive to electrical forces, said work station including an electrically conductive enclosure including electrically conductive window means for viewing the interior of the enclosure through an aperture; wherein said electrically conductive window means includes a recessed area completely surrounding said aperture, a sheet of optically transparent material located in said recessed area, said sheet having at least an electrically conductive surface and completely covering said aperture, and said window means further including an electrically-conductive frame-like structure maintaining electrically conductive communication between said enclosure and said surface to shield the interior of said enclosure from external electrical forces, characterized by means for substantially reducing lateral movement of said sheet along said recessed area.

In order that the present invention may more readily be understood, the following description is given, merely by way of example, with reference to the accompanying drawings, in which:—

Figure 1 is a perspective view of a preferred embodiment of an electrically conductive work station or container in accordance with the present invention;

Figure 2 is a cross-sectional, schematic representation of the shielding effect of the electrically conductive container of Figure 1 when the container is placed in an electromagnetic field as represented by the lines of electrical force;

Figure 3 is a cross-sectional, schematic representation of the lack of shielding afforded by an electrically non-conductive container when said container is placed in an electromagnetic or electrostatic field as represented by the lines of electrical force;

Figure 4 is a cross-sectional schematic representation of the shielding effect of the electrically conductive container of Figure 1 when the container is placed in an electrostatic field as represented by the lines of electric force;

Figure 5 is a top plan view of the electrically conductive container in which the window sheet and the sheet engaging and retaining means have been removed;

Figure 6 is a front elevation of the electrically conductive container of Figure 5;

Figure 7 is a left side elevation of the electrically conductive container of Figure 5;

Figure 8 is a top plan view of a preferred window sheet engaging and retaining means in accordance with the present invention;

Figure 9 is a cross-sectional view of a preferred window sheet in accordance with the present invention;

Figure 10 is a cross-sectional view of a preferred window means taken along line D—D in Figure 17;

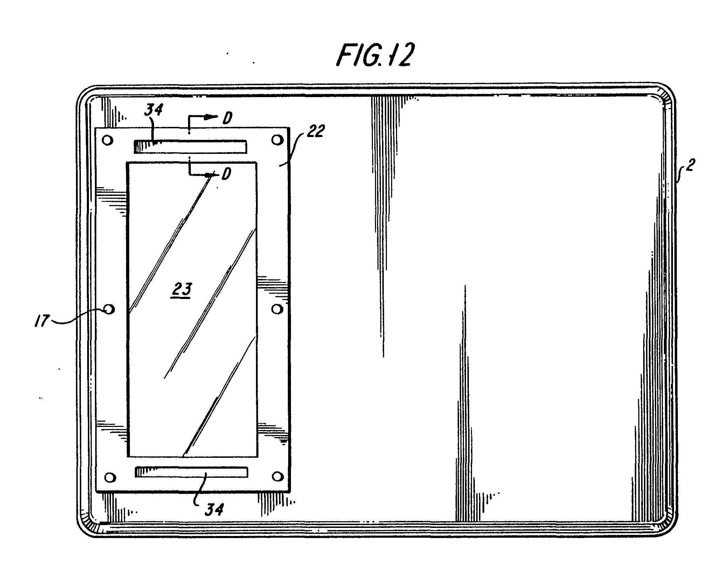

Figure 11 is an enlarged cross-sectional view of the preferred window means in accordance with the present invention; and

Figure 12 is a top plan view of a preferred window means of the top enclosure means of the electrically conductive container of Figure 1.

Throughout the drawings like reference numerals represent like structure or means. Figure 1 is a

perspective view of a preferred embodiment of a portable work station for transporting and/or storing electrically sensitive repair or replacement parts to an on-site field location without subjecting the stored parts to the potentially harmful effects of external electrical forces (fields). It can be seen that the portable work station comprises an electrically conductive container 1, preferably formed by blow molding.

The container is manufactured from a blend of (1) any of the conventional thermoplastic materials which have heretofore been utilized in prior art blow molding processes and (2) particles of an electrically conductive material. Generally, any material which may assume a thermoplastic state can be utilized as the thermoplastic material incorporated within the blend. Such materials are generally blow molded in the temperature range of 250°—600°F (121—312°C). Polyethylene is a preferred material. Other exemplary materials are high-density polyethylene, polypropylene, polyvinyl chloride and elastomeric polyolefins. These materials are generally known not to be electrically conductive. Accordingly, particles of an electrically conductive material must be blended therewith to render the composition of the final enclosure electrically conductive. Exemplary of such an electrically conductive material is carbon black particles. However, other electrically conductive materials such as, for example, aluminum particles may be utilized. Most metal filings are suitable but weight considerations dictate a preference toward lighter particles or filings. A particularly preferred blend of the materials is from 75—85 percent, by weight, of the thermoplastic material and from 15—25 percent, by weight, of the carbon black particles. An especially preferred blend is approximately 83 percent, by weight, of the thermoplastic material and approximately 17 percent, by weight, of the carbon black particles. The most preferred enclosure composition is from 75—85, preferable 83, percent, by weight, of polyethylene blended with from 15—25, preferably 17 percent, by weight, of carbon black particles. Of course, small amounts of additives which serve to enhance the processability of the composition may be included as is well known to those in the art. An example of such additives are mold release additives.

The two materials are blended, heated to extrusion temperature, extruded as a parison and blow molded into the desired shape.

Figure 1 shows a portable work station or container 1 comprising a top enclosure means 2 and a bottom enclosure means 3 connected by flexible hinge means 4 (see Figures 5 and 7). Upon closing of container 1 the top enclosure means 2 and bottom enclosure means 3 are brought into close intimate contact and are interfaced along parting line 5. Container 1 may also contain a flexible latching means 6, preferably a latch gripping tab or extension 7, for releasably securing top enclosure means 2 to bottom enclosure means 3.

Various portions or surfaces of container 1 may also be provided with label areas 8 shaped and sized so as to match up with adhesively applied labels (not shown). Preferably one or more of the areas 8 are slightly recessed or sunken. Alternatively logos or other trade indicia may be included within the areas 8, for example by recessing the area and raising the logo above the recessed surface.

Container 1 also includes an electrical charge bleed-off or grounding means 9 on either enclosure means 2 or 3, but preferably on bottom enclosure means 3 and more preferably conductively attached thereto by way of a well-known male-female arrangement. Bleed-off means 9 is also formed from an electrically conductive material such as, for example, any electrically conductive metal (e.g. copper, aluminum etc.) and may take the form of a snap juncture or, alternatively, it may merely assume a pole or rod-like configuration to which clipping means such as, for example, an alligator clip may be attached.

The container or work station 1 comprises a window means 10 comprising a sheet of optically transparent material 11 incorporated within, for example, the top enclosure means 2 by an electrically conducting frame-like retaining and engaging means 12 manufactured from a composition such as one of those described above with regard to means 2 and 3, and preferably of the same composition as means 2 and 3.

Figure 5 is a top plan view of the electrically conductive container of Figure 1 wherein the optically transparent sheet 11 and the frame-like sheet engaging and retaining means 12 have been removed to reveal the presence of orifice 23 in container top enclosure means 2. Orifice 23 is peripherally surrounded by window means recess area 22. A group of holes 17 located in the recessed window area 22 serves to receive and to retainingly engage legs of sheet-engaging and retaining means 12. Accordingly, to ensure firm engagement of the legs in holes 17, the diameter of holes 17 should be equal to or slightly less than the diameter of the legs. Alternatively, the legs could be longer than the depth of holes 17 and have enlarged ends to snappingly engage holes 17. However, a sufficient number of holes 17 and associated cooperating legs should be provided so that engaging and retaining means 12 can trappingly retain sheet 11 between means 12 and window means recess 22.

The structure of sheet-engaging and -retaining means 12 is clearly disclosed in Figure 8. Figure 8, which is a top plan view of means 12, shows the preferred frame-like configuration of means 12 which surrounds opening 18.

Figure 12 discloses a preferred window area in which window means recess 22 of top enclosure means 2 includes a window stop recess 34 which accommodates a window stop rib 32 of the sheet-retaining and -engaging means 12. The window stop rib 32 of the sheet-retaining and -engaging means 12, and the inclusion of a window stop recess 34 to the window means recess 22 of top enclosure means 2 substantially eliminate lateral movement of window sheet 11 along the window recess area 22 of top enclosure means 2, thereby reducing the possibility of dust or other foreign matter entering the container 1.

Reduction of lateral movement of window sheet 11 also reduces the possibility of a discontinuity in the electrically conductive surface of container 1. Additionally, the force with which window sheet 11 is engaged and retained within window-retaining indent 20 on recess means 22 of top enclosure 2 by the means 12 becomes much less critical.

Although, as shown in Figure 9, many of the optically transparent materials generally utilized for window sheets or panes 24, for example polycarbonates and glass, are not electrically conductive and must be coated with an electrically conductive coating 25 to render the entire surface of the container electrically conductive, electrically conductive communicative contact between the electrically conductive coating and the remainder of the electrically conductive enclosure is ensured by the present configuration.

The electrically conductive coating 25 onto a non-conducting surface 24 may, for example, be provided by cathode sputtering, for example with an indium tin oxide. Other methods of coating are possible, as disclosed in U. S. Patents 4,369,208; 4,303,554; and 4,268,539.

The container preferably includes an internal pad, preferably a foam anti-static pad, made of an electrically conductive material to reduce or eliminate the generation and accumulation of internal static electricity. A preferred material for the pad is known in the art as "pink poly". This material is a polyethylene which has been impregnated with an organic liquid which acts as a hydroscopic "wetting agent" which attracts and holds moisture onto the surface of the pad to render the pad electrically conductive. U.S. patent 3,355,313 and Canadian Patent No. 810,595 disclose exemplary wetting agents.

Alternatively, the pad could be formed from an electrically conductive loaded plastic foam such as a carbon- or aluminum-loaded polyurethane foam. This material is available in commercial volumes and is electrically conductive throughout, as opposed to merely having an electrically conductive surface coating. Yet another type of conductive pad is a polyethylene foam which has been sprayed with a conductive carbon or similar conductive solution to effect a conductive layer on the surface of the material.

The internal pad may be preformed to the configuration of the electrically sensitive devices which may then be securely held thereby. Additionally, the pad is shaped and inserted into the container so as to be in electrically conductive communication with the electrically conductive enclosure means of the container. As a result of the conductivity of the internal pad and its electrically conductive communication with the container, any static charge which might be generated by frictional movement or other slight vibrations of the electrically sensitive device against the pad will immediately be conducted to, and (if the container is not grounded) reside on, the external surface of the container. Moreover, it is believed that the presence of a moist surface on the pad reduces the generation of friction and the accompanying static forces.

Another possible and also known method for rendering plastic materials, both foamed and non-foamed, anti-static is the dispersal of an anti-static agent throughout the plastic. Initially, since continuity of the agent throughout the plastic is lacking, the anti-static properties are not good. However, in time, the agent migrates to the surface of the material much like the phenomenon known as migration (sweating) of incompatible plasticizers. Thus, after a period of time, a good conductive anti-static coating is formed. A recommended compound of this sort is: stearamidopropyldimethyl-2-hydroxyethylammonium nitrate, a cationic surface-active agent having the following structure:

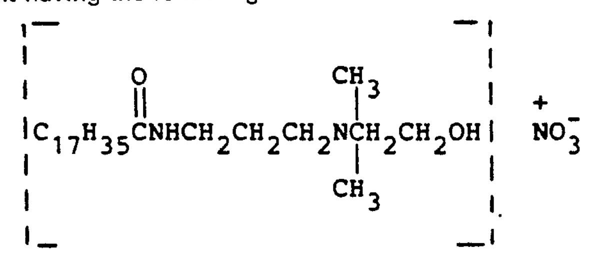

The function of charge bleed-off means 9 is to afford a means for the easy attachment of one end of an electrically conductive wire whose other end carries a similar attachment means for electrically conductive communication with the machine or other device which is to be repaired in the field. Accordingly, any differential of electrical charge which may exist between the container and the machine will be equalized upon attachment of the wire. Thus, if the repair technician maintains physical/electrically conductive communicative contact with the machine to be repaired, (i.e. grounds himself with respect to the machine), the electrically sensitive device will not be subjected to the adverse effects of uncontrolled electrical flow or discharge upon being incorporated within the machine being repaired.

Figure 3 schematically demonstrates the penetration of the interior 16 of a prior art electrically non-conductive container by an external electromagnetic or electrostatic field. Conversely Figures 2 and 4 schematically illustrate the shielding effect which the present conductive case affords to its interior 16 and to any devices contained therein when the container is placed in an electromagnetic field (Figure 2) or an electrostatic field (Figure 4).

The double-wall construction shown in Figures 2 and 4 is preferred as affording a greater degree of physical protection to the contents. Both single and double wall blow molding are well known to those of skill in the art, and either type may be used.

An additional significant function which the present conductive container performs is the bleeding-off of any internally generated static electrical charge from the electrically sensitive device to the surface of the

container. The charge bled off by means 9 may come from a source of electrical charge in the vicinity of the electrically sensitive device, or may have been built up on the surface of the portable work station as a result of transportation of the work station (e.g. static from the repair technician walking).

## Claims

1. A portable work station adapted to transport a device which is sensitive to electrical forces, said work station including an electrically conductive enclosure including electrically conductive window means for viewing the interior of the enclosure through an aperture; wherein said electrically conductive window means includes a recessed area completely surrounding said aperture, a sheet of optically transparent material located in said recessed area, said sheet having at least an electrically conductive surface and completely covering said aperture, and said window means further including an electrically conductive frame-like structure maintaining electrically conductive communication between said enclosure and said surface to shield the interior of said enclosure from external electrical forces, characterized by means for substantially reducing lateral movement of said sheet along said recessed area.

2. A work station according to claim 1, characterised in that said means for substantially reducing lateral movement of said sheet includes a further recess formed within the first mentioned recessed area, and a protrusion forming a portion of the electrically conductive frame-like structure, said protrusion being accommodated within said recess and being positioned to confine the optically transparent sheet against lateral movement.

3. A work station according to claim 2, characterized in that said protrusion comprises a rib extending along the frame-like structure, and the further recess comprises a groove to receive the rib.

4. A work station according to any one of the preceding claims, characterized in that the optically transparent sheet is of an electrically non-conductive material and is coated with an electrically conductive material.

5. A work station according to any one of the preceding claims, characterized in that the container is a double-walled blow molded container.

## Patentansprüche

1. Tragbare Arbeitsstation zum Transport einer Einrichtung, die gegenüber elektrischen Kräften empfindlich ist, wobei die Arbeitsstation ein elektrisch leitendes Gehäuse mit einem elektrisch leitenden Fenstermittel zum Betrachten des Inneren des Gehäuses durch eine Öffnung aufweist; wobei das elektrisch leitende Fenstermittel einen vertieften Bereich umfaßt, der die Öffnung vollständig umgibt, wobei ein Blatt von optisch transparentem Material in dem ausgenommenen Bereich angeordnet ist, das Blatt mindestens eine elektrisch leitende Fläche besitzt und die Öffnung vollständig überdeckt, und wobei das Fenstermittel ferner eine elektrisch leitfähige, rahmenartige Struktur aufweist, die eine elektrisch leitende Verbindung von dem Gehäuse zu der Fläche aufrechterhält, um das Innere des Gehäuses gegen äußere elektrische Kräfte abzuschirmen, gekennzeichnet durch Mittel zum wesentlichen Reduzieren der seitlichen Bewegung des Blattes in dem vertieften Bereich.

2. Arbeitsstation nach Anspruch 1, dadurch gekennzeichnet, daß das Mittel zum wesentlichen Reduzieren der seitlichen Bewegung des Blattes eine weitere Vertiefung aufweist, die in dem zuerst erwähnten vertieften Bereich gebildet ist, und daß ein Forsatz einen Teil der elektrisch leitfähigen rahmenartigen Struktur bildet, wobei der Forsatz in der Vertiefung aufgenommen und angeordnet ist, um das optisch transparente Blatt gegenüber seitlicher Bewegung festzuhalten.

3. Arbeitsstation nach Anspruch 2, dadurch gekennzeichnet, daß der Fortsatz eine Rippe aufweist, die sich entlang der rahmenartigen Struktur erstreckt, und daß die weitere Vertiefung eine Nut zur Aufnahme der Rippe besitzt.

4. Arbeitsstation nach einem der vorhergehenden Ansprüche, dadurch gekennzeichnet, daß das optisch transparente Blatt aus einem elektrisch nicht leitfähigen Material besteht und mit einem elektrisch leitfähigen Material beschichtet ist.

5. Arbeitsstation nach einem der vorhergehenden Ansprüche, dadurch gekennzeichnet, daß der Behälter ein doppelwandiger, blasgeformter Behälter ist.

## Revendications

1. Poste de travail portatif adapté pour transporter un dispositif qui est sensible aux forces électriques, ledit poste de travail comprenant une enceinte électriquement conductrice incluant un moyen de fenêtre électriquement conducteur pour voir l'intérieur de l'enceinte à travers une ouverture, dans lequel ledit moyen de fenêtre électriquement conducteur comprend une zone évidée entourant complètement ladite ouverture, une feuille de matériau optiquement transparent située dans ladite zone évidée, ladite feuille ayant au moins une surface électriquement conductrice et couvrant complètement ladite ouverture, et ledit moyen de fenêtre comprenant en outre une structure enforme de cadre électriquement conductrice

maintenant une communication électriquement conductrice entre ladite enceinte et ladite surface pour protéger l'intérieur de ladite enceinte des forces électriques externes, caractérisé par des moyens pour réduire sensiblement le mouvement latéral de ladite feuille le long de ladite zone évidée.

2. Poste de travail selon la revendication 1, caractérisé en ce que ledit moyen pour réduire sensiblement le mouvement latéral de ladite feuille comprend un autre évidement formé à l'intérieur de la zone évidée mentionnée en premier lieu, et une protubérance formant une partie de la structure électriquement conductrice en forme de cadre, ladite protubérance étant logée à l'intérieur dudit évidement et étant positionnée pour confiner ladite feuille optiquement transparente par rapport à un mouvement latéral.

3. Poste de travail selon la revendication 2, caractérisé en ce que ladite protubérance comprend une nervure s'étendant le long de la structure en forme de cadre, et en ce que l'évidement supplémentaire comprend une rainure pour recevoir la nervure.

4. Poste de travail selon l'une des revendications précédentes, caractérisé en ce que la feuille optiquement transparente est en un matériau électriquement non conducteur et est revêtue d'un matériau électriquement conducteur.

5. Poste de travail selon l'une des revendications précédentes, caractérisé en ce que le coffret est un coffret soufflé à double paroi.

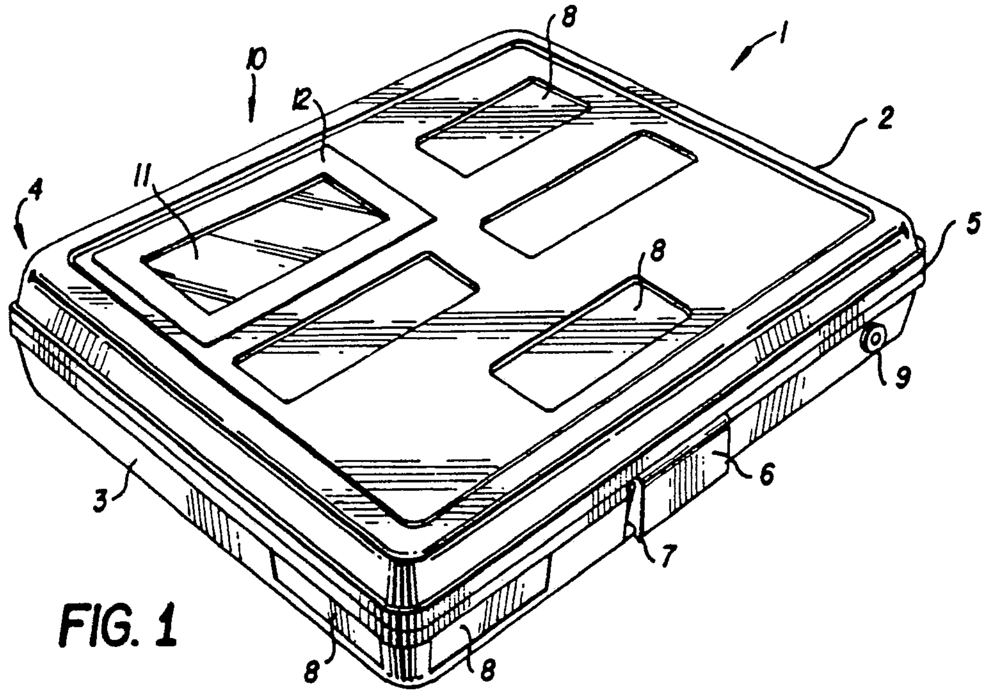


FIG. 1

FIG. 2

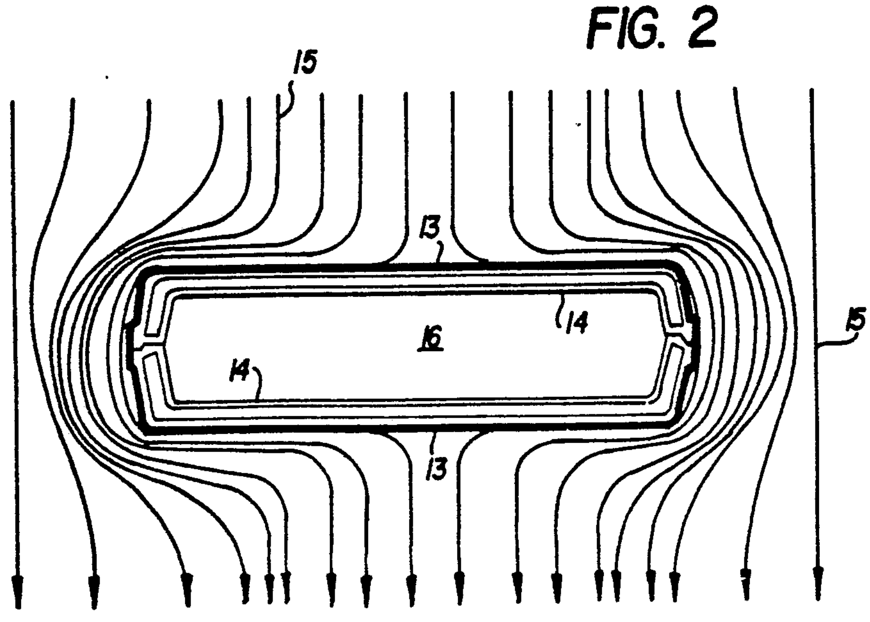

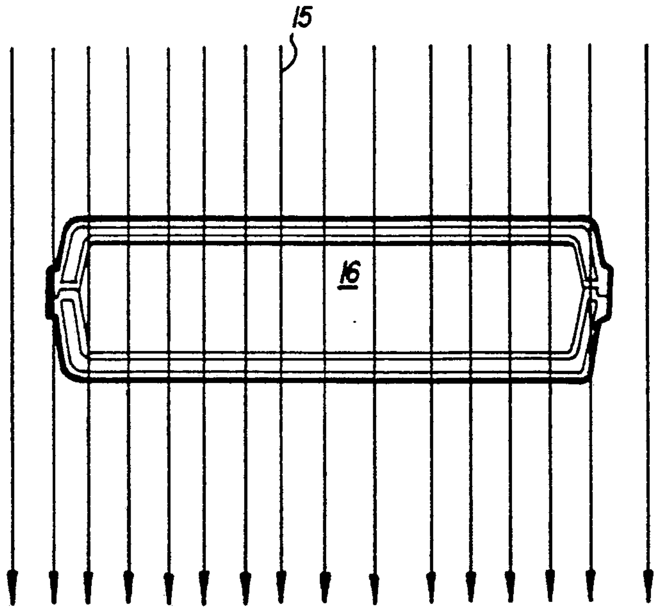


FIG. 3

FIG. 4

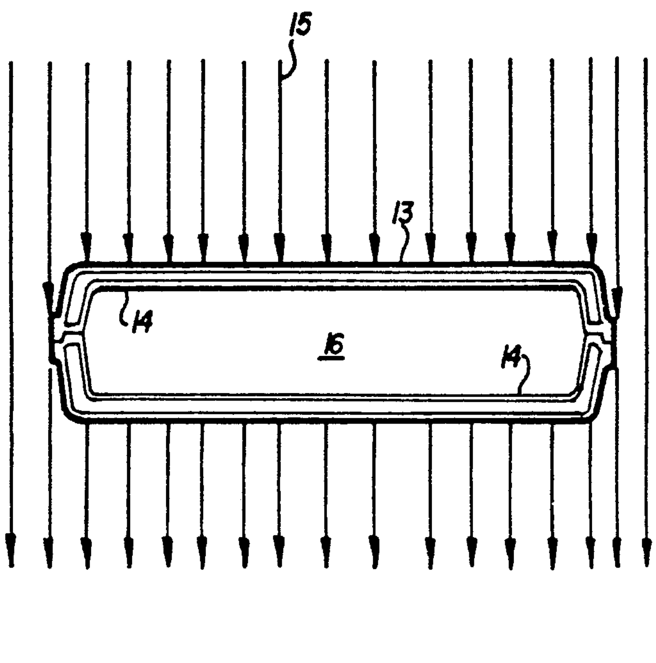

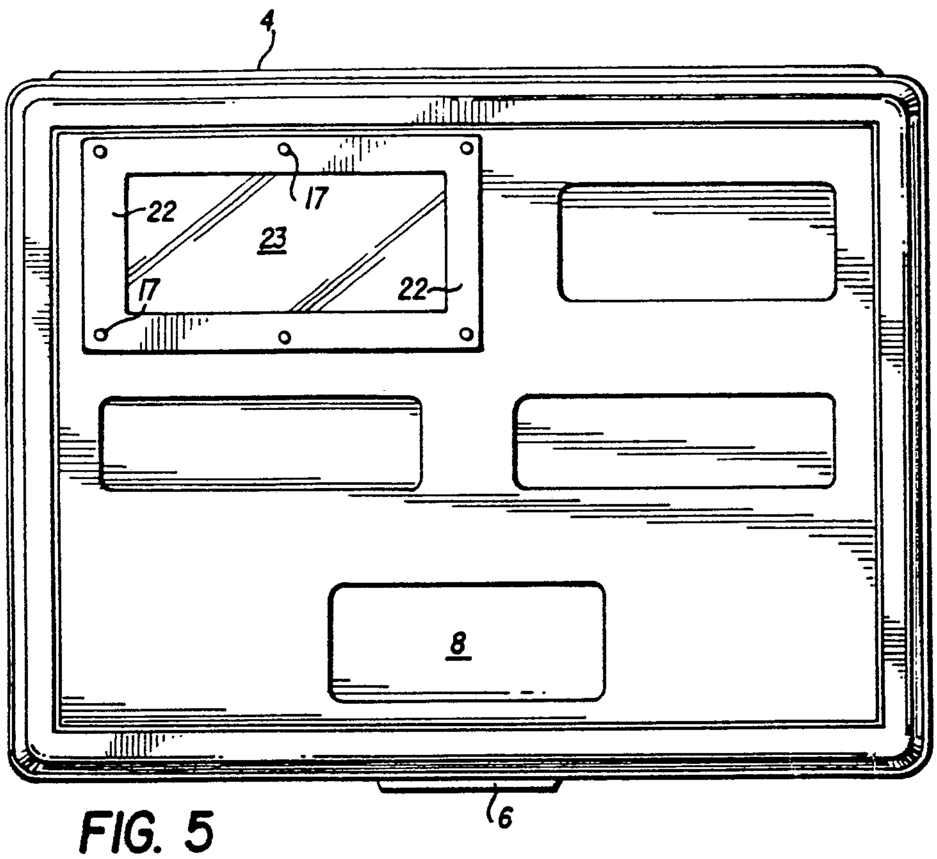


FIG. 5

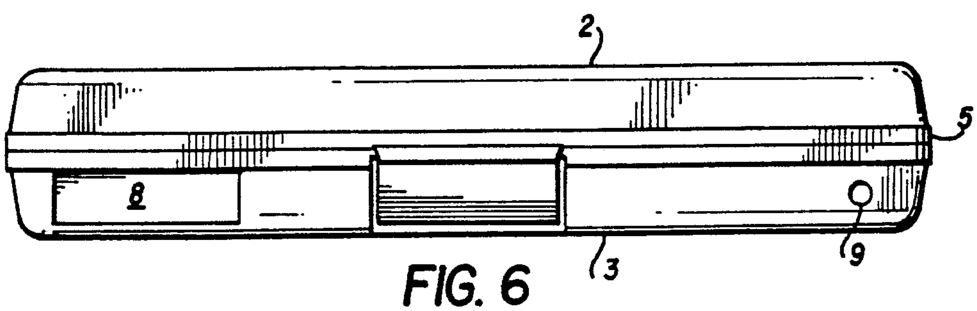


FIG. 6

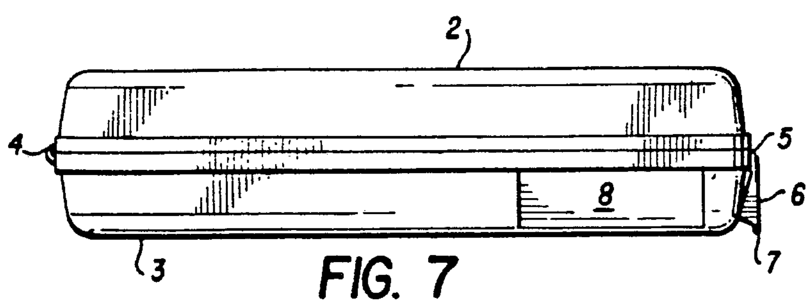


FIG. 7

FIG. 8

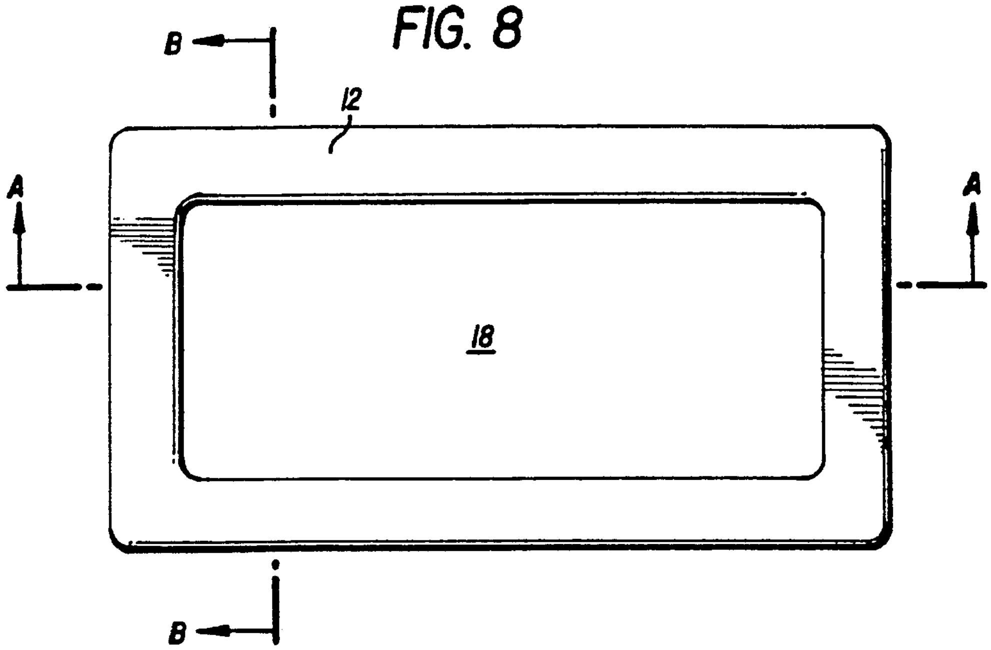


FIG. 9

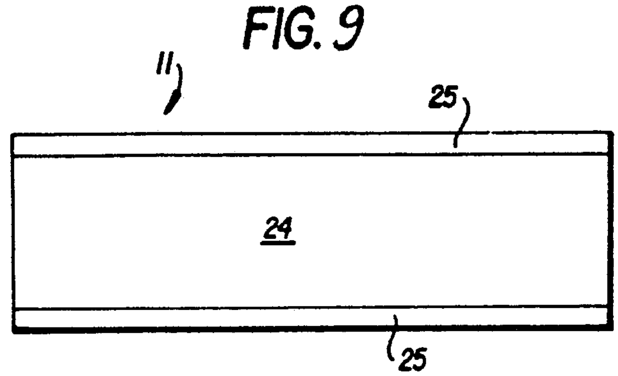

FIG. 10

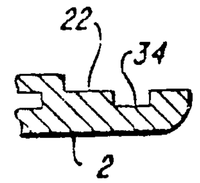


FIG. 11

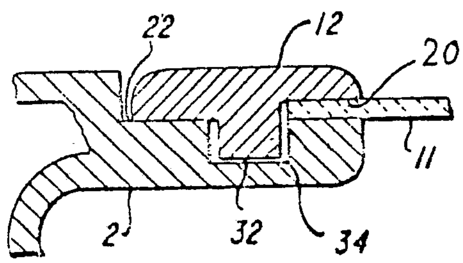

FIG.12